**Europäisches Patentamt**

**European Patent Office**

**Office européen des brevets**

(19)

(11) Veröffentlichungsnummer : **0 095 755**
**B1**

(12) **EUROPÄISCHE PATENTSCHRIFT**

(45) Veröffentlichungstag der Patentschrift :
01.02.89

(51) Int. Cl.⁴ : **H 01 L 29/06**, H 01 L 29/78

(21) Anmeldenummer : **83105282.4**

(22) Anmeldetag : **27.05.83**

(54) **Halbleiterbauelement mit Planarstruktur.**

(30) Priorität : **28.05.82 DE 3220250**

(43) Veröffentlichungstag der Anmeldung :
**07.12.83 Patentblatt 83/49**

(45) Bekanntmachung des Hinweises auf die Patenterteilung : **01.02.89 Patentblatt 89/05**

(84) Benannte Vertragsstaaten :
**CH DE FR GB IT LI**

(56) Entgegenhaltungen :
**EP--A-- 0 037 115**
**CH--A-- 501 311**
**US--A-- 3 573 571**
**US--A-- 3 767 981**
**IBM TECHNICAL DISCLOSURE BULLETIN, Band 19, Nr. 2, Juli 1976, Seiten 478,479, New York, US; C.G. JAMBOTKAR: "Spaced field plate for increasing planar junction breakdown voltage"**

(73) Patentinhaber : **Siemens Aktiengesellschaft Berlin und München**
**Wittelsbacherplatz 2**
**D-8000 München 2 (DE)**

(72) Erfinder : **Fellinger, Christine**
**Germersheimerstrasse 5**
**D-8000 München 90 (DE)**
Erfinder : **Leipold, Ludwig, Dipl.-Ing.**
**Kurt-Eisner-Strasse 41**
**D-8000 München 83 (DE)**
Erfinder : **Tihanyi, Jenö, Dr.-Ing.**
**Wolfratshauser Strasse 179 b**
**D-8000 München 71 (DE)**

EP 0 095 755 B1

**Beschreibung**

Die Erfindung bezieht sich auf ein planares Halbleiterbauelement mit einem Substrat vom ersten Leitungstyp, mit einer planar in die eine Oberfläche des Substrats eingebetteten kontaktierten Zone vom entgegengesetzten Leitungstyp, mit einer Steuerelektrode, die einen an die eine Oberfläche tretenden Teil der genannten Zone überdeckt, mit einer Isolierschicht auf der einen Oberfläche, mit einer am Rand des Substrats auf der Isolierschicht sitzenden Randelektrode, die elektrisch mit dem Substrat verbunden ist, und mit mindestens einem zwischen dem Substratrand und der Zone angeordneten, planar in die eine Oberfläche eingebetteten Schutzring entgegengesetzten Leitungstyps.

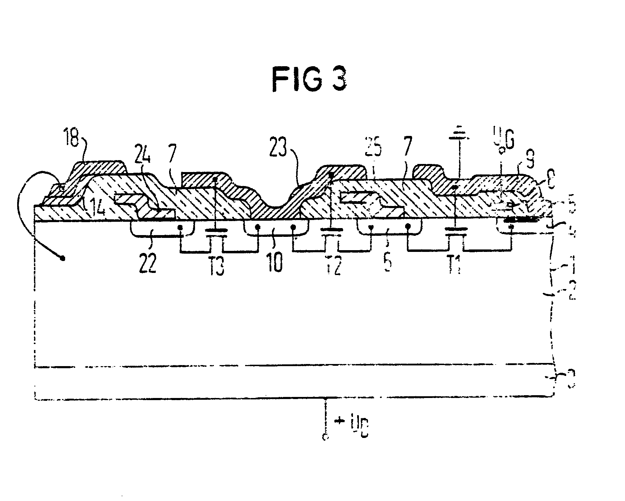

In der DE-A-30 12 430 ist in Verbindung mit Fig. 3 ein Halbleiterbauelement dieser Gattung in Gestalt eines MISFET beschrieben worden. Ein bekanntes Problem bei einem MISFET und bei anderen Planar-Halbleiterbauelementen besteht darin, daß die maximale Sperrspannung außer von der Krümmung der Raumladungszone auch von den Verhältnissen an der Oberfläche des Halbleitersubstrats abhängig ist. Die Einflüsse an der Oberseite werden durch verschiedene Arten von Passivierungsschichten bekämpft. Die Krümmung der Raumladungszone läßt sich durch speziell geformte Feldplatten, durch am Substratrand angebrachte, im wesentlichen auf Substratpotential liegende Randelektroden und durch zwischen der Randelektrode und den planaren Zonen angeordnete Schutzringe günstig beeinflussen. Die genannten Maßnahmen sollen bewirken, daß die Äquipotentiallinien möglichst gleichmäßig verteilt durch die Substratoberfläche nach außen treten. Das heißt, daß die Oberflächenfeldstärke so weit vergleichmäßigt wird, daß eine Annäherung an die durch das Substratinnere vorgegebene maximale Sperrspannung möglich ist.

Es hat sich jedoch gezeigt, daß die Sperrspannungsverteilung an der Oberfläche vielfach instabil war, was durch eine Wechselwirkung der in den Passivierungsschichten vorhandenen und freibeweglichen Ionen mit dem oder den Schutzringen zurückzuführen ist.

Die der Erfindung zugrunde liegende Aufgabe ist eine Verbesserung eines Planar-Halbleiterbauelements der eingangs erwähnten Gattung derart, daß die Feldverteilung an der Oberfläche des Substrats zwischen planaren Zonen und Substratrand weitgehend stabil bleibt.

Die Erfindung ist dadurch gekennzeichnet, daß zumindest derjenige Teil des Substrats, der zwischen dem Schutzring und der genannten Zone an die Oberfläche tritt, von mindestens einer leitenden Schicht vollständig überdeckt ist, daß die leitende Schicht vom genannten Teil des Substrats elektrisch isoliert ist und daß sie mit einer der planar eingebetteten Zonen elektrisch kontaktiert ist.

Weiterbildungen der Erfindung sind Gegenstand der Unteransprüche.

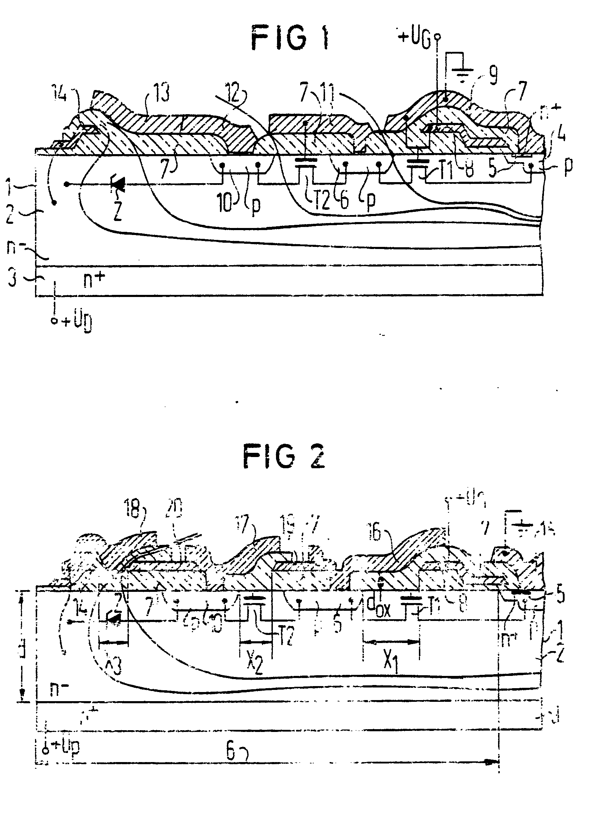

Die Erfindung wird an Hand einiger Ausführungsbeispiele in Verbindung mit den Fig. 1 bis 3 näher erläutert. Diese Figuren zeigen Schnitte durch die Halbleiterkörper dreier MISFET.

Das MIS-Halbleiterbauelement nach Fig. 1 hat ein Substrat 1, das aus einer stark dotierten Schicht 3 und einer darauf z. B. durch epitaktische Abscheidung aufgebrachten relativ schwach dotierten Schicht 2 besteht. In die eine Oberfläche des Substrats 1 ist eine Zone 4 vom entgegengesetzten Leitungstyp planar eingebettet. Diese Zone ist die Kanalzone des MIS-Halbleiterbauelements. In die Kanalzone 4 ist eine relativ hochdotierte Zone 5 vom ersten Leitungstyp planar eingebettet. Diese Zone bildet die Sourcezone des MIS-Halbleiterbauelements. Auf dem Substrat kann auch eine Vielzahl von z. B. im Raster angeordneten aus den Zonen 4 und 5 bestehenden Zellen angeordnet sein. Die gezeigte Zelle stellt dann die dem Rand des Substrats benachbarte Zelle dar.

In der Oberfläche des Substrats 1 sind zwischen der Zelle (4, 5) und dem Rand zwei Schutzringe 6, 10 des dem Substrat entgegengesetzten Leitungstyps angeordnet. Die Oberfläche des Substrats ist mit einer Isolierschicht 7, z. B. aus SiO₂, bedeckt. In der Isolierschicht 7 sind Öffnungen angebracht, durch die die Zelle 4, 5 durch eine leitende Schicht 9 kontaktiert ist. Der Schutzring 6 ist durch eine leitende Schicht 11 und der Schutzring 10 durch eine leitende Schicht 12 kontaktiert. Die leitende Schicht 9 überdeckt den zwischen Schutzring 6 und der Kanalzone 4 an die Oberfläche tretenden Teil des Substrats 1 und ist elektrisch gegen diesen Teil isoliert. Sie kann auch den Schutzring 6 überlappen. Sie überdeckt auch eine zur Steuerung der Zelle 4, 5 vorgesehene Gateelektrode 8. Mit dem ersten Schutzring 6 ist eine leitende Schicht 11 kontaktiert, die den zweiten Schutzring 10 überlappen kann. Die leitende Schicht 11 überdeckt den zwischen den Schutzringen 10 und 6 an die Oberfläche tretenden Teil des Substrats 1.

Die leitenden Schichten schirmen nun die Substratoberfläche gegen äußere freibewegliche Ionen ab, so daß die Oberflächendurchbruchsspannung von diesen nicht mehr beeinflußt werden kann. Das Halbleiterbauelement kann nun so betrachtet werden, als ob der erste Schutzring 6 mit der Kanalzone 4 einen p-Kanal-Lateral-FET bildet, dessen Gateelektrode die auf Sourcepotential (Massepotential) liegende leitende Schicht 9 ist. Im vorliegenden Fall bildet die erste Schutzzone 6 die Sourcezone und die Kanalzone 4 die Drainzone des p-Kanal-Lateral-FET, der in der Figur mit T 1 symbolisiert ist. Die für die Steuerung der Zelle 4, 5 vorgesehene Gateelektrode 8 liegt bei gesperrtem MISFET ebenfalls auf Massepotential, so daß die leitende Schicht 9 und die Gateelektrode 8 als eine gemeinsame Gateelektrode für T 1 betrachtet werden kann. Der zweite Schutzring 10 bildet zusammen mit dem ersten Schutzring 6 und der leitenden Schicht 11 einen zweiten p-Kanal-Lateral-FET T 2. Bei komplementär aufgebauten Halbleiterbauelementen sind T 1 und T 2 n-Kanal-FET. Beide Transistoren T 1, T 2 sind in Reihe geschaltet.

Zur Erläuterung der Funktion sei angenommen, daß an den Elektroden des MIS-Halbleiterbauelements eine Spannung $+U_D$ liegt. Damit bildet sich eine Verteilung von Äquipotentiallinien aus, die den gezeigten Verlauf hat. Hierbei bildet sich an der Oberfläche des Substrats eine Spannung aus, die als Drain-Source-Spannung für die beiden in Serie geschalteten Lateral-FET T 1 und T 2 wirkt. Der zwischen dem zweiten Schutzring 10 und dem Rand des Substrats bzw. der Randelektrode 14 liegende Teil des Substrats kann als Zenerdiode mit einer bestimmten Durchbruchsspannung aufgefaßt werden. Ihre Durchbruchsspannung ist kleiner als die Durchbruchsspannung im Substratinneren. In der Figur ist dies durch eine Zenerdiode Z symbolisiert. An der Serienschaltung der Transistoren T 1 und T 2 liegt daher die Spannungsdifferenz aus der Spannung $+U_D$ und der an der Zenerdiode Z abfallenden Spannung an. Ist die an Z abfallende Spannung z. B. 700 V und beträgt die Spannung $+U_D$ 1000 V, so muß, um Oberflächendurchbrüche zu vermeiden, die Reihenschaltung der Lateral-MISFET die Differenz von 300 V aufnehmen.

Diejenige Spannung, die die p-Kanal-Lateral-FET aufnehmen können, wird durch ihre Einsatzspannungen bestimmt, da die als Gateelektroden wirkenden leitenden Schichten 9 und 11 jeweils mit der Drainzone der Transistoren T 2, T 1 kontaktiert sind. Die Einsatzspannung wiederum läßt sich durch die Dicke der Isolierschicht 7 bestimmen. Die leitenden Schichten 9, 11 und 12 können beispielsweise aus Aluminium bestehen. Mit einer Spannung $+U_D = 1000$ V, mit einer Dicke der Isolierschicht 7 von $SiO_2$ zwischen 2 und 3 μm, bei einer Dotierung der Zone 2 von 40 bis 50 Ohm cm und einer Dicke von 80 bis 90 μm erhält man eine Sperrspannung pro Lateral-MISFET von 100 bis 150 V. Zwischen dem Rand des Substrats und der Schutzzone 10 muß dann bei der oben angegebenen Substratdotierung eine Entfernung von 60 bis 100 μm liegen, um die Restspannung von 700 bis 800 V aufnehmen zu können.

In Fig. 1 wurde ein MIS-Halbleiterbauelement mit zwei Schutzringen dargestellt. Es ist jedoch auch möglich, ein solches Halbleiterbauelement nur mit einem einzigen oder mit mehr als zwei Schutzringen und leitenden Schichten auszurüsten. Wieviel Schutzzonen und leitende Schichten vorgesehen sein müssen, richtet sich nach der Forderung, daß die Summe der Einsatzspannungen der Lateral-FET und der Durchbruchsspannung der Rand- « Zenerdiode » Z größer als die Durchbruchsspannung im Substratinneren sein muß. Die mit dem weiteren, dem Rand des Substrats benachbarten Schutzring verbundene leitende Schicht 12 überlappt das Substrat in Richtung zum Rand und dient als Feldplatte. Sie kann auch weiter in Richtung Rand des Substrats herausgezogen werden (13) und die Randelektrode 14 überlappen.

Beim Ausführungsbeispiel nach Fig. 1 sind die Gateelektroden der Lateral-FET jeweils mit ihrer Drainzone kurzgeschlossen. Es ist jedoch auch möglich, die Lateral-FET so aufzubauen, daß ihre Gateelektroden mit den entsprechenden Sourcezonen kurzgeschlossen sind. Eine solche Anordnung ist in Fig. 2 gezeigt. Der erste Schutzring 6 ist dort mit einer leitenden Schicht 16 kontaktiert, die die Gateelektrode 8 überlappt. Mit der Zelle 4, 5 ist eine leitende Schicht 15 kontaktiert, die ihrerseits wieder die Gateelektrode 8 überlappt, gegen die leitende Schicht 16 jedoch isoliert ist. Der zweite Schutzring 10 ist mit einer leitenden Schicht 17 kontaktiert, die für den Fall, daß sie alleine die Funktion der Gateelektrode für den durch die Schutzringe 6 und 10 gebildeten Lateral-FET übernimmt, den ersten Schutzring 6 überlappen muß. In diesem Ausführungsbeispiel ist die Gateelektrode für den genannten Lateral-FET gemeinsam durch die leitende Schicht 17 und eine mit der leitenden Schicht 16 verbundene Feldplatte 19 gebildet. Die leitende Schicht 17 überlappt dabei die Feldplatte 19. Ähnlich ist die Gateelektrode für den Lateral-FET T 1 aus der Gateelektrode 8 und der die Gateelektrode 8 überlappenden leitenden Schicht 16 gebildet. Die sich überlappenden Schichten liegen zwar auf verschiedenen Potentialen, dies spielt jedoch dann keine Rolle, wenn das Gatepotential, das Material und Dicke des Isolators und die Entfernung zur Oberfläche des Substrats aufeinander abgestimmt sind. Ebenso kann die leitende Schicht 17 auf der dem Rand zugewandten Seite mit einer den zweiten Schutzring 10 und das Substrat überlappenden Feldplatte 20 versehen sein. Die Feldplatten bestehen vorzugsweise aus dotiertem polykristallinem Silicium. Mit Hilfe der Feldplatten kann eine Vergleichmäßigung der Oberflächenfeldstärke erreicht werden.

Soll jeder der Lateral-FET die gleiche Spannung aufnehmen, sollten die lateralen Abstände x zwischen Feldplatte und Schutzring zum Rand hin abnehmen. Diese Abstände bestimmen zusammen mit anderen Parametern die am Lateral-FET abfallende Punch-Through-Spannung. Sie kann größer sein als die Einsatzspannung in der Ausführung nach Fig. 1, so daß diese Lösung größeren Spannungsabfall pro Lateral-FET erlaubt.

Bei Anlegen einer Sperrspannung in der eingezeichneten Richtung fällt an T 1 und T 2 wiederum die Differenz aus der Spannung $+U_D$ und der zwischen dem Rand und dem zweiten Schutzring 10 gedacht liegenden Zenerdiode abfallenden Spannung ab. Die an den Lateral-FET abfallenden Spannungen lassen sich durch die Dicke der Isolierschicht, durch das Material der Isolierschicht, durch die Dicke d und die Dotierung der Zone 2 sowie durch die angelegte Spannung $U_D$ einstellen. Die oben erwähnten Abstände $x_1$, $x_2$, $x_3$ werden z. B. 15, 10, 6 bis 8 μm groß gemacht. Allgemein sollten sie mindestens um den Faktor 10 kleiner als die Oxiddicke sein.

In Fig. 3 ist ein Ausführungsbeispiel dargestellt, das so erläutert werden kann, als ob die Gateelektroden der Lateral-FET teilweise mit der Sourcezone und teilweise mit der Drainzone kurzgeschlossen sind. Der gezeigte MISFET ist um einen dritten Schutzring 22 erweitert. Der zweite Schutzring 10 ist mit einer leitenden Schicht 23 kontaktiert, die sowohl den ersten Schutzring 6 als auch den dritten Schutzring 22 überlappt. Damit werden zwei Lateral-FET T 3 und T 2 gebildet, während der erste Lateral-FET 1 dem nach Fig. 1 entspricht. Die Schutzringe 6 und 22 können noch mit Feldplatten 25 bzw. 24 verbunden sein, die von den leitenden Schichten 23 bzw. der Randelektrode 18 überlappt werden.

Die dargestellten Ausführungsbeispiele stellen Vertikal-MISFET dar. Die Erfindung ist jedoch auch für Lateral-MISFET, für durch Feldeffekt gesteuerte Thyristoren und und Triacs oder allgemein für Planarstrukturen, auch mit bipolarem Leitungsmechanismus anwendbar.

**Patentansprüche**

1. Planares Halbleiterbauelement mit einem Substrat (1) vom ersten Leitungstyp, mit einer planar in die eine Oberfläche des Substrats eingebetteten kontaktierten Zone (4) vom entgegengesetzten Leitungstyp, mit einer Steuerelektrode (8), die einen an die eine Oberfläche tretenden Teil der genannten Zone (4) überdeckt, mit einer Isolierschicht (7) auf der einen Oberfläche, mit einer am Rand des Substrats auf der Isolierschicht sitzenden Randelektrode (14), die elektrisch mit dem Substrat (1) verbunden ist, und mit mindestens einem zwischen dem Substratrand und der Zone (4) angeordneten Schutzring (6, 10), der als weitere planar in die eine Oberfläche eingebettete Zone entgegengesetzten Leitungstyps ausgebildet ist, dadurch gekennzeichnet, daß zumindest derjenige Teil des Substrats (1), der zwischen dem Schutzring (6) und der genannten Zone (4) an die Oberfläche tritt, von mindestens einer leitenden Schicht (9 ; 16, 8) vollständig überdeckt ist, daß die leitende Schicht vom genannten Teil des Substrats elektrisch isoliert ist und daß sie mit einer der planar eingebetteten Zonen (4 ; 6) elektrisch kontaktiert ist.

2. Halbleiterbauelement nach Anspruch 1, dadurch gekennzeichnet, daß der genannte Teil des Substrats (1) von einer einzigen leitenden Schicht (9) überdeckt wird, und daß diese diejenige planar eingebettete Zone (6) überlappt, gegen die sie elektrisch isoliert ist.

3. Halbleiterbauelement nach Anspruch 1, dadurch gekennzeichnet, daß der genannte Teil des Substrats von mindestens zwei sich überlappenden, elektrisch gegeneinander isolierten, leitenden Schichten (8, 16) überdeckt ist, daß mindestens eine der leitenden Schichten (16) mit einer der planar eingebetteten Zonen (6) elektrisch kontaktiert ist und daß mindestens an eine andere der leitenden Schichten ein Potential anlegbar ist.

4. Halbleiterbauelement nach Anspruch 3, dadurch gekennzeichnet, daß die andere der leitenden Schichten durch die Gateelektrode (8) eines MISFET gebildet ist.

5. Halbleiterbauelement nach Anspruch 3, dadurch gekennzeichnet, daß die andere der leitenden Schichten mit der anderen der planar eingebetteten Zonen kontaktiert ist.

6. Halbleiterbauelement nach Anspruch 1, dadurch gekennzeichnet, daß zwischen der Randelektrode (14) und dem Schutzring (6) mindestens ein weiterer Schutzring (10) vom entgegengesetzten Leitungstyp planar eingebettet ist, und daß derjenige Teil des Substrats, der zwischen den Schutzringen (6, 10) an die Oberfläche tritt, von mindestens einer leitenden Schicht (11, 23) vollständig überdeckt ist und daß die leitende Schicht mit der ersten oder dem zweiten Schutzring kontaktiert ist.

7. Halbleiterbauelement nach Anspruch 6, dadurch gekennzeichnet, daß der genannte Teil des Substrats von zwei sich überlappenden leitenden, elektrisch gegeneinander isolierten Schichten überdeckt ist und daß die eine Schicht (16, 19) mit dem einen Schutzring (6) und die andere (17) mit den anderen Schutzring (10) kontaktiert ist.

8. MIS-Halbleiterbauelement nach einem der Ansprüche 1 bis 7, dadurch gekennzeichnet, daß die die Schutzringe (6, 10) kontaktierenden leitenden Schichten (16, 17) je mit einer Feldplatte (19, 20) verbunden sind, die das Substrat auf der der Randelektrode zugekehrten Seite überlappen, und daß die Feldplatte (19) des ersten Schutzrings (6) von der den zweiten Schutzring (10) kontaktierenden leitenden Schicht (17) überlappt wird, jedoch elektrisch gegen diese isoliert ist.

9. MIS-Halbleiterbauelement nach Anspruch 8, dadurch gekennzeichnet, daß die Feldplatte (20) des der Randelektrode benachbarten Schutzrings (10) von der Rfandelektrode (14) überlappt und elektrisch gegen diese isoliert ist.

10. MIS-Halbleiterbauelement nach einem der Ansprüche 1 bis 9, dadurch gekennzeichnet, daß die leitenden Schichten aus Aluminium und die Feldplatten aus dotiertem Polysilicium bestehen.

**Claims**

1. Planar semiconductor component having a substrate (1) of the first type of conduction, with a contacted zone (4) of the opposite type of conduction which is embedded in a planar manner into one surface of the substrate, with a control electrode (8) which covers a part, which emerges on one surface, of the said zone (4), with an insulation layer (7) on one surface, with an edge electrode (14) which is located at the edge of the substrate on the insulation layer an which is electrically connected to the substrate (1), and with at least one protective ring (6, 10) which is arranged between the substrate edge and the zone (4) and which is constructed as further zone of the opposite type of conduction which is embedded in a planar manner into one surface, characterized in that at least the part of the substrate (1) which emerges on the surface between the protective ring (6) and the said zone (4) is completely covered by at least one conductive layer (9; 16, 8), that the conductive layer is electrically insulated from the said part of the substrate, and that it is in electric contact with one of the zones (4; 6) which are embedded in a planar manner.

2. Semiconductor component according to Claim 1, characterized in that the said part of the substrate (1) is covered by a single conductive layer (9) and that this layer overlaps the zone (6) embedded in a planar manner, against which it is electrically insulated.

3. Semiconductor component according to Claim 1, characterized in that the said part of the substrate is covered by at least two mutually overlapping conductive layers (8, 16) which are electrically insulated from one another, that at least one of the conductive layers (16) is in electric contact with one of the zones (6) which are embedded in a planar manner, and that a potential can be applied to at least one other of the conductive layers.

4. Semiconductor component according to Claim 3, characterized in that the other one of the conductive layers is formed by the gate electrode (8) of a MISFET.

5. Semiconductor component according to Claim 3, characterized in that the other one of the conductive layers is in contact with the other one of the zones which are embedded in a planar manner.

6. Semiconductor component according to Claim 1, characterized in that at least one further protective ring (10) of the opposite type of conduction is embedded in a planar manner between the edge electrode (14) and the protective ring (6), and that the part of the substrate which emerges at the surface between the protective rings (6, 10) is completely covered by at least one conductive layer (11, 23) and that the conductive layer is in contact with the first or the second protective ring.

7. Semiconductor component according to Claim 6, characterized in that the said part of the substrate is covered by two mutually overlapping conductive layers which are electrically insulated with respect to one another and that one layer (16, 19) is in contact with one protective ring (6) and the other one (17) is in contact with the other protective ring (10).

8. MIS semiconductor component according to one of Claims 1 to 7, characterized in that the conductive layers (16, 17) which are in contact with the protective rings (6, 10) are each connected to a field plate (19, 20) and overlap the substrate on the side facing the edge electrode, and that the field plate (19) of the first protective ring (6) is overlapped by the conductive layer (17) which is in contact with the second protective ring (10), but is electrically insulated from this conductive layer.

9. MIS semiconductor component according to Claim 8, characterized in that the field plate (20) of the protective ring (10) adjacent to the edge electrode is overlapped by the edge electrode (14) and is electrically insulated from the latter.

10. MIS semiconductor component according to one of Claims 1 to 9, characterized in that the conductive layers consist of aluminium and the field plates consist of doped polysilicon.

**Revendications**

1. Composant à semiconducteurs planar comportant un substrat (1) possédant un premier type de conductivité, une zone (4) à établissement d'un contact, insérée selon la disposition planar dans une première surface du substrat et possédant le type de conductivité opposé, et une électrode de commande (8) qui recouvre une partie, située au niveau de la première surface, de la zone (4) indiquée, une couche isolante (7) située sur la première surface, une électrode marginale (14) située sur le bord du substrat sur la couche isolante et reliée électriquement au substrat (1), et au moins un anneau de protection (6, 10) situé entre le bord du substrat et la zone (4) et réalisé sous la forme d'une zone supplémentaire insérée selon la disposition planar dans la première surface et possédant le type de conductivité opposé, caractérisé par le fait qu'au moins la partie du substrat (1), qui est située entre l'anneau de protection (6) et ladite zone (4) au niveau de la surface, est complètement recouverte par au moins une couche conductrice (9; 16, 8), que la couche conductrice est isolée électriquement par rapport à ladite partie du substrat et qu'elle est en contact électrique avec l'une des zones (4; 6) insérées selon la disposition planar.

2. Composant à semiconducteurs suivant la revendication 1, caractérisé par le fait que ladite partie du substrat (1) est recouverte par une seule couche conductrice (9) et que cettre couche recouvre la zone (6) insérée selon la disposition planar et par rapport à laquelle elle est isolée électriquement.

3. Composant suivant la revendication 1, caractérisé par le fait que ladite partie du substrat est recouverte par au moins deux couches conductrices (8, 16), qui se chevauchent et sont isolées électriquement l'une par rapport à l'autre, qu'au moins l'une des couches conductrices (16) est placée en contact électrique avec l'une des zones (6) insérées selon la disposition planar et qu'au moins un potentiel peut être appliqué à une autre des couches conductrices.

4. Composant à semiconducteurs suivant la revendication 3, caractérisé par le fait que l'autre des couches conductrices est formée par l'électrode de grille (8) d'un transistor MISFET.

5. Composant à semiconducteurs suivant la revendication 3, caractérisé par le fait que l'autre des couches conductrices est placée en contact avec l'autre des zones insérées selon la disposition planar.

6. Composant à semiconducteurs suivant la revendication 1, caractérisé par le fait qu'entre l'électrode marginale (14) et l'anneau de protection (6) se trouve inséré, selon la disposition planar, au moins un autre anneau de protection (10) possédant le type de conductivité opposé, et que la partie du substrat, qui apparaît entre les anneaux de protection (6, 10) au niveau de la surface, est complètement recouverte par au moins une couche conductrice (11, 23) et que la couche conductrice est placée en contact avec le premier anneau protecteur ou le second anneau protecteur.

7. Composant à semiconducteurs suivant la revendication 6, caractérisé par le fait que ladite partie du substrat est recouverte par deux couches conductrices, qui se chevauchent et sont électriquement isolées l'une par rapport à l'autre, et qu'une couche (16, 19) est en contact avec l'anneau de protection (6) et que l'autre couche (10) est en contact avec l'autre anneau de protection (10).

8. Composant à semiconducteurs MIS suivant l'une des revendications 1 à 7, caractérisé par le fait que les couches conductrices (16, 17), qui sont en contact avec les anneaux de protection (6, 10), sont reliées à des magnétorésistances respectives (19, 20), qui chevauchent le substrat sur la face tournée vers l'électrode marginale, et que la couche conductrice (17), qui est en contact avec le second anneau de protection (10), chevauche la magnétorésistance (19) du premier anneau de protection (6), tout en en étant isolée électriquement.

9. Composant à semiconducteurs MIS suivant la revendication 8, caractérisé par le fait que l'électrode marginale (14) chevauche la magnétorésistance (20) de l'anneau de protection (10) voisin de l'électrode marginale, et en est électriquement isolée.

10. Composant à semiconducteurs MIS suivant l'une des revendications 1 à 9, caractérisé par le fait que les couches conductrices sont réalisées en aluminium et que les magnétorésistances sont formées par du silicium dopé.

## FIG 1

## FIG 2

# FIG 3